# EUROPEAN PATENT APPLICATION

(11) **EP 4 847 463 A1**
(43) Date of publication of application: **02.12.2026**
(21) Application number: 25828083.3
(22) Date of filing: 12.08.2025
(51) Int. Cl.: C03C 6/04

(54) **PHOTOSENSITIVE GLASS AND PREPARATION METHOD THEREFOR, REINFORCED PHOTOSENSITIVE GLASS, AND USE**

(30) Priority: 12.08.2024 CN 202411102164
(71) Applicant: Chongqing Aureavia Hi-Tech Glass Co., Ltd., Chongqing 400713 (CN)
(72) Inventor: LUO, Site, Beibei District, Chongqing 400713 (CN); HUANG, Hao, Beibei District, Chongqing 400713 (CN); YIN, Weiwei, Beibei District, Chongqing 400713 (CN); TIAN, Qian, Beibei District, Chongqing 400713 (CN)
(74) Representative: Dantz, Dirk
(86) International application number: PCT/CN2025/114188
(87) International publication number: WO 2026/037299

(57) **Abstract**

The embodiments of the present disclosure provide a photosensitive glass and a preparation method therefor, a strengthened photosensitive glass and use thereof. By controlling the raw material composition of the photosensitive glass, it not only ensures the stability of the glass composition during the melting process of Ag₂O-containing photosensitive glass and solves the problem of loss and damage to noble metal containers caused by silver atoms Ag⁰ generated from the decomposition of Ag₂O, but also ensures that the exposed area of the photosensitive glass obtained after subsequent radiation treatment and heat treatment exhibits extremely low optical transmittance in the visible and near-infrared wavelength ranges, thereby achieving shielding of optical signals.

## Description

### CROSS-REFERENCE TO RELATED APPLICATIONS

The present disclosure claims priority to Chinese Patent Application No. 202411102134.4, titled "PHOTOSENSITIVE GLASS AND PREPARATION METHOD THEREFOR, STRENGTHENED PHOTOSENSITIVE GLASS AND USE THEREOF", filed before the China National Intellectual Property Administration on August 12, 2024, which is incorporated herein by reference in its entirety.

### TECHNICAL FIELD

The present disclosure relates to the technical field of glass, in particular to a photosensitive glass and a preparation method thereof, a strengthened photosensitive glass and use thereof.

### BACKGROUND

Photosensitive glass is capable of responding to external optical stimulation. Under certain illumination conditions, the structure and phase of the glass will change, exhibiting different mechanical, optical and other properties. Ag-containing photosensitive glass is the most common type among photosensitive glasses. And Ag is usually combined with Ce ions and Sb ions. During the melting process, Sb³⁺ can transfer electrons to Ce⁴⁺, reducing it to Ce³⁺. Upon subsequent ultraviolet (UV) exposure, Ce³⁺ can transfer electrons to Ag⁺, reducing it to Ag⁰. These Ag⁰ serves as a growth center for colloidal Ag crystals. Subsequent heat treatment can promote the precipitation and growth of Ag colloids. Due to the proximity of lattice constants, Ag colloidal crystals can induce the precipitation of lithium metasilicate crystals. Based on the above reaction chain principle, Corning and SCHOTT have respectively developed Fotoform/Fotoceram and Foturan products. By the subsequent etching of the glass, micro-area mechanical processing of the glass can be achieved, used for MEMS, TGV, and microfluidic glass chips, etc.

The melting process for Ag-containing photosensitive glass presents many challenges. For example, using containers made of materials such as corundum and quartz can greatly affect the final glass composition during high-temperature melting, and the melting containers are also prone to breakage. However, using containers made of noble metals (especially metal containers of platinum, rhodium, etc.), the Ag in the glass composition can corrode the container. Prolonged melting can cause serious damage and destruction to the container (melting containers comprise crucibles, furnaces, channels, etc.). Therefore, ensuring the stability of the melting process, maintaining stable glass composition, reducing and avoiding damage to the container during the melting process are technical problems that urgently need to be solved.

The application of this system of photosensitive glass is mainly concentrated in the field of glass micro-mechanical processing, while the use in optics has not been reported. Actually, in the UV-exposed area, the optical transmittance of photosensitive glass will significantly decrease with the precipitation of colloidal Ag crystals and the precipitation of lithium silicate crystals. This characteristic allows Ag photosensitive glass-ceramics to be used for shielding of optical signals. By employing a process that combines UV exposure with a mask to define specific areas, it becomes possible to create regions that effectively shield against optical signals within a predetermined wavelength range.

It should be noted that the content in this part of the present disclosure only provides background information related to the present disclosure and does not necessarily constitute prior art or common general knowledge.

### SUMMARY

An object of the present disclosure is to provide a photosensitive glass, which not only can ensure the stability of the glass composition during the melting process of Ag₂O-containing photosensitive glass and solve the problem of loss and damage to a noble metal container caused by silver atoms Ag⁰ generated from the decomposition of Ag₂O, but also can ensure that the exposed area of the photosensitive glass obtained after subsequent radiation treatment and heat treatment exhibits extremely low optical transmittance in the visible and near-infrared wavelength ranges, thereby achieving shielding of optical signals.

In order to achieve the above object, the present disclosure provides the following technical solutions:
A first aspect provides a photosensitive glass, comprising the following components: 50 wt% to 60 wt% of silica sand, 15 wt% to 22 wt% of lithium carbonate, 6 wt% to 10 wt% of aluminum hydroxide, 3 wt% to 6 wt% of potassium nitrate, 3 wt% to 6 wt% of sodium nitrate, 3 wt% to 5 wt% of zirconium oxide, 0.3 wt% to 0.6 wt% of silver nitrate, 0.05 wt% to 0.10 wt% of cerium oxide, and a pentavalent antimony salt, based on a mass percentage of each component of a raw material in the photosensitive glass; wherein, calculated as sodium antimonate, a mass percentage of the pentavalent antimony salt in the photosensitive glass is 0.3 wt% to 0.8 wt%.

Optionally, the photosensitive glass comprises the following components:
silica sand with a content of 53 wt% to 59 wt%, preferably silica sand with a content of 54.00 wt% to 58.96 wt%, and/or
lithium carbonate with a content of 17 wt% to 20 wt%, preferably lithium carbonate with a content of 17.43 wt% to 19.94 wt%, and/or
aluminum hydroxide with a content of 8 wt% to 10 wt%, preferably aluminum hydroxide with a content of 8.22 wt% to 9.97 wt%, and/or
potassium nitrate with a content of 4 wt% to 6 wt%, preferably potassium nitrate with a content of 4.07 wt% to 5.97 wt%, and/or
sodium nitrate with a content of 3.5 wt% to 5.5 wt%, preferably sodium nitrate with a content of 3.77 wt% to 5.45 wt%, and/or
zirconium oxide with a content of 3.33 wt% to 5 wt%, preferably zirconium oxide with a content of 3.33 wt% to 4.96 wt%, and/or
silver nitrate with a content of 0.3 wt% to 0.5 wt%, preferably silver nitrate with a content of 0.32 wt% to 0.49 wt%, and/or
cerium oxide with a content of 0.05 wt% to 0.09 wt%, preferably cerium oxide with a content of 0.06 wt% to 0.09 wt%, and/or
the pentavalent antimony salt with a content of 0.3 wt% to 0.7 wt%, preferably the pentavalent antimony salt with a content of 0.3 wt% to 0.5 wt%,
based on the mass percentage of each component of the raw material in the photosensitive glass.

Optionally, the pentavalent antimony salt comprises at least one selected from the group consisting of NaSbO₃, KSbO₃, NH₄SbO₃, and a hydrate thereof.

Optionally, a thickness of the photosensitive glass is 0.4 mm to 2.0 mm.

Optionally, the photosensitive glass comprises an exposed area and a non-exposed area, when the thickness of the photosensitive glass is 0.40 mm to 1.00 mm, a transmittance T₁ of the exposed area of the photosensitive glass at a wavelength of 850 nm is 0.00% to 5.00%, preferably the transmittance T₁ is 0.00% to 3.00%; and/or when the thickness of the photosensitive glass is 0.40 mm to 1.00 mm, a transmittance T₂ of the exposed area of the photosensitive glass at a wavelength of 550 nm is 0.00% to 5.00%, preferably the transmittance T₂ is 0.00% to 2.00%; and/or when the thickness of the photosensitive glass is 0.40 mm to 1.00 mm, a transmittance T₃ of the non-exposed area of the photosensitive glass at a wavelength of 850 nm is more than or equal to 90%; and/or when the thickness of the photosensitive glass is 0.40 mm to 1.00 mm, a transmittance T₄ of the non-exposed area of the photosensitive glass at a wavelength of 550 nm is more than or equal to 90%.

A second aspect provides a preparation method for the photosensitive glass as described above, comprising:
proportioning each component of the raw material, then mixing and melting in a noble metal container, followed by molding, and then performing annealing treatment to obtain a substrate glass;
the substrate glass comprises a first area and a second area, performing masking treatment on the first area, not performing masking treatment on the second area, to obtain a masked substrate glass; and
after performing radiation treatment and heat treatment on the masked substrate glass, obtaining the photosensitive glass having the non-exposed area and the exposed area; wherein the non-exposed area corresponds to the first area, and the exposed area corresponds to the second area.

Optionally, the noble metal container is a container prepared by using at least one metal comprising gold, platinum, and rhodium.

Optionally, a temperature of the melting is 1400°C to 1650°C, and a time of the melting is 6 h to 48 h.

Optionally, a temperature of the annealing is 400°C to 500°C, and a time of the annealing is 8 h to 24 h.

Optionally, the masking treatment comprises masking using a masking ink and/or a mask.

Optionally, the radiation treatment comprises ultraviolet irradiation treatment.

Optionally, a wavelength of the ultraviolet irradiation treatment is 300 nm to 320 nm, an intensity of the ultraviolet irradiation treatment is 20 mW/cm² to 360 mW/cm², and a time of the ultraviolet irradiation treatment is 5 min to 60 min.

Optionally, the heat treatment comprises nucleation treatment and crystallization treatment.

Optionally, a heating rate of the nucleation treatment is 1°C/min to 10°C/min; and/or
a temperature of the nucleation treatment is 430°C to 540°C; and/or
a time of the nucleation treatment is 30 min to 360 min; and/or
a heating rate of the crystallization treatment is 1°C/min to 10°C/min; and/or
a temperature of the crystallization treatment is 540°C to 800°C; and/or
a time of the crystallization treatment is 30 min to 480 min.

Optionally, the thickness of the substrate glass is 0.4 mm to 2.0 mm.

A third aspect provides a strengthened photosensitive glass. The strengthened photosensitive glass has a thickness t and comprises a strengthening layer and a tensile stress layer, wherein the strengthening layer extends inward from a surface of the strengthened photosensitive glass, a thickness of the strengthening layer is greater than 0 and less than or equal to 0.22 t;
the tensile stress layer and/or a center of the strengthened photosensitive glass comprises the following components:
SiO₂: 65.00% to 74.00%, Al₂O₃: 5.00% to 10.00%, Li₂O: 7.90% to 12.00%, Na₂O: 1.00% to 3.00%, K₂O: 1.50% to 3.80%, ZrO₂: 3.50% to 6.50%, Ag₂O: 0.20% to 0.50%, CeO₂: 0.07% to 0.13% and Sb₂O₃: 0.20% to 0.50%, based on a mass percentage of oxides;
the strengthening layer comprises the following components:
   SiO₂: 65.00% to 74.00%, Al₂O₃: 5.00% to 10.00%, Na₂O: 4.00% to 16.00%, K₂O: 2.0% to 5.0%, ZrO₂: 3.50% to 6.50%, Ag₂O: 0.20% to 0.50%, CeO₂: 0.07% to 0.13% and Sb₂O₃: 0.20% to 0.50%, based on the mass percentage of oxides; a content of Li₂O in the strengthening layer is lower than a content of Li₂O in the tensile stress layer and/or at the center of the strengthened photosensitive glass;
   wherein, Na₂O is obtained from sodium nitrate, K₂O is obtained from potassium nitrate, Ag₂O is obtained from silver nitrate, and Sb₂O₃ is obtained from a pentavalent antimony salt;
   the strengthened photosensitive glass comprises a non-exposed area and an exposed area.

Optionally, t is 0.4 mm to 2.0 mm.

Optionally, a uniaxial compressive strength of the strengthened photosensitive glass is more than or equal to 200 N, preferably 200 N to 500 N, more preferably 200 N to 490 N.

A fourth aspect provides a cover plate glass made of the photosensitive glass according to any one of the embodiments of the first aspect, the photosensitive glass prepared by the preparation method according to any one of the embodiments of the second aspect, or the strengthened photosensitive glass according to any one of the embodiments of the third aspect.

A fifth aspect provides an electronic device, comprising the photosensitive glass according to any one of the embodiments of the first aspect, the photosensitive glass prepared by the preparation method according to any one of the embodiments of the second aspect, or the strengthened photosensitive glass according to any one of the embodiments of the third aspect.

Optionally, the electronic device comprises a shell having a top and a bottom, a shell part at the bottom comprises the photosensitive glass according to any one of the embodiments of the first aspect, the photosensitive glass prepared by the preparation method according to any one of the embodiments of the second aspect, or the strengthened photosensitive glass according to the third aspect.

Optionally, the electronic device further comprises a camera component, a housing of the electronic device comprises a camera protection cover plate, the camera protection cover plate covers the camera module, and the camera protection cover plate comprises the photosensitive glass according to any one of the embodiments of the first aspect, the photosensitive glass prepared by the preparation method according to any one of the embodiments of the second aspect, or the strengthened photosensitive glass according to the third aspect.

A sixth aspect provides a use of the photosensitive glass according to any one of the embodiments of the first aspect, the photosensitive glass prepared by the preparation method according to any one of the embodiments of the second aspect, or the strengthened photosensitive glass according to any one of the embodiments of the third aspect in the manufacture of a component for a mobile phone, a smartwatch, a wearable device, a camera module, or a vehicle.

Compared with the prior art, one or more of the above technical solutions provided by the present disclosure comprises the following advantages:
By controlling the raw material composition of the photosensitive glass, it is possible to ensure the stability of the glass composition during the melting process of Ag₂O-containing photosensitive glass and solve the problem of loss and damage to a noble metal container caused by silver atom Ag⁰ generated from the decomposition of Ag₂O. Moreover, it is also possible to ensure that he exposed area of the photosensitive glass obtained after subsequent radiation treatment and heat treatment exhibits extremely low optical transmittance in the visible and near-infrared wavelength ranges, thereby achieving shielding of optical signals.

### BRIEF DESCRIPTION OF THE DRAWINGS

In order to illustrate the technical solutions of the examples of the present disclosure more clearly, the drawings required for describing the examples will be briefly introduced below. It should be understood that the following drawings show only some examples of the present disclosure and therefore should not be considered as limiting the scope. For those of ordinary skill in the art, other related drawings can be obtained based on these drawings without creative effort.
FIG. 1 is a structural schematic diagram of a substrate glass after masking using masking ink according to an embodiment of the present disclosure.
FIG. 2 is a structural schematic diagram of a photosensitive glass according to an embodiment of the present disclosure.
FIG. 3 is a structural schematic diagram of an electronic device as a mobile phone according to an embodiment of the present disclosure.
FIG. 4 is a structural schematic diagram of an electronic device as a smartwatch mentioned in an embodiment of the present disclosure.
FIG. 5 shows photographs of the inner side of the crucible after melting for Examples 9-10 and Comparative Examples 1-2 of the present disclosure; wherein a. is a photograph of the bottom of the crucible for Comparative Example 1, b. is a photograph of the bottom of the crucible for Comparative Example 2, c. is a photograph of the bottom of the crucible for Example 9, d. is a photograph of the bottom of the crucible for Example 10.
FIG. 6 shows physical images of shielding in the visible light range for the exposed area of Examples 9-10 and Comparative Examples 1-3 of the present disclosure. The bright light spots transmitting through in Comparative Examples 1-3 are red light.

Reference numerals: 11 - light-transmitting area; 12 - light-shielding area; 21 - exposed area; 22 - non-exposed area; 31 - camera protection cover plate; 32 - camera component; 33 - back cover; 41 - a shell part at the bottom of the smartwatch.

### DETAILED DESCRIPTION

The embodiments of the present disclosure will be described in detail below with reference to the examples. However, those skilled in the art will understand that the following examples are only configured to illustrate the present disclosure and should not be regarded as limiting the scope of the present disclosure. If specific conditions are not indicated in the examples, they are carried out according to conventional conditions or the conditions recommended by the manufacturer. Reagents or instruments for which the manufacturer is not indicated are all commercially available conventional products.

The endpoints and any values of the ranges disclosed herein are not limited to the precise ranges or values, and these ranges or values should be understood to comprise values close to these ranges or values. For numerical ranges, the endpoint values of each range, the endpoint values of each range and separate point values, as well as separate point values can be combined with each other to obtain one or more new numerical ranges, which should be considered as specifically disclosed herein. Among them, the terms "optional" and "optionally" both refer to that they may be comprised or may not be comprised (or may exist or may not exist). The term "and/or" as used herein is inclusive, for example, "A and/or B" refers to only A, or only B, or both A and B.

### Term Explanation and Test Methods:

In the present disclosure, the main surface refers to the surface with the largest area, for example, the upper surface or lower surface of a horizontally placed substrate glass.

In the present disclosure, when light of a certain wavelength irradiates the main surface of the photosensitive glass, the light will be reflected, absorbed, and transmitted. The ratio of the intensity of the transmitted part to the intensity of the incident light is the transmittance.

In the present disclosure, the thickness of the glass was tested with a micrometer.

In the present disclosure, the dimensional specifications of the glass sheets were tested using a 2D video measuring machine (instrument model Miyu MY-YXCL-4030).

### Main Surface Ag/Ag₂O Concentration Test

The surface Ag/Ag₂O concentration of the photosensitive glass in the present disclosure was measured by X-ray fluorescence spectrometer (XRF). The equipment used for testing was Thermo Scientific ARL^{™} PERFORM'X. The target was Rh (rhodium), the X-ray tube voltage was 40 kV, the current was 60 mA, the collimator was 0.15, the crystal selected was LiF200, the detector selected was FPC, the test area was a 29 mm circle, and the analysis software was UniQuant standardless analysis. During XRF testing, standardless testing was used. The concentration of elements or their oxides with atomic number 6 and below in the glass was not tested. Specifically, for example, SiO₂, Al₂O₃, Na₂O, K₂O, etc. can be accurately tested, while Li₂O, B₂O₃, etc. cannot be accurately tested. That is, in the present disclosure, when testing the surface Ag/Ag₂O concentration by XRF, the total mass of surface elements or their oxides does not include the mass of elements or their oxides with atomic number 6 and below in the glass.

In the present disclosure, an ultraviolet-visible spectrophotometer was used to test the transmittance of the exposed area and the non-exposed area of the glass to be tested. The ultraviolet-visible spectrophotometer used for testing in the present disclosure was Shimadzu's UV-2000 ultraviolet-visible spectrophotometer.

The specific method for testing the exposed area of the glass to be tested was as follows: first, a jig with the same shape and size as the glass to be tested, where the corresponding area of the exposed area of the glass to be tested was a hollowed-out area and the corresponding area of the non-exposed area of the glass to be tested was a light-proof area, and the connection position between the hollowed-out area and the light-proof area was light-proof, was used as a blank sample for test calibration. Then, the exposed area of the glass to be tested was cut into a sample that coincided with the shape of the hollowed-out area of the jig and placed into the hollowed-out area of the aforementioned jig for testing to obtain the transmittance. The ultraviolet-visible spectrophotometer was used to test the transmittance of the exposed area of five pieces of glass to be tested from the same batch to light of different wavelengths, and then the average value was taken, which was recorded as the transmittance result of the exposed area of the glass to be tested at that wavelength of light.

In addition, the ultraviolet-visible spectrophotometer was used to test the transmittance of the non-exposed area of five pieces of glass to be tested from the same batch to light of different wavelengths. The average value of the transmittance measured for the non-exposed area of the five pieces of glass to be tested at different wavelengths of light was taken, and recorded as the transmittance result of the non-exposed area of the glass to be tested at that wavelength of light.

In the present disclosure, the uniaxial compressive strength test can be performed as follows: the glass sample sheet to be tested was placed on the bottom ring of a tensile testing machine (LT-850A), the testing software was started, the moving speed of the extrusion rod (rod diameter 8 mm, press head arc radius 10 mm) was set to 50 mm/min, and the test was started. The extrusion rod applied force to the center of the glass sample sheet to be tested at the set moving speed until cracked appeared and glass sample sheet broke. The test software automatically read the force (N) at the time the glass sample sheet broke as the test result. Ten glass sample in the same state were tested, and the average value of the test results was taken as the uniaxial compressive strength of the glass sample sheet to be tested.

In the present disclosure, the wavelength range of visible light and near-infrared refers to 400 nm to 1000 nm.

In the present disclosure, the glass composition comprises Ag₂O, which undergoes the following reversible reaction during the melting process: ${Ag}_{2} O ↔ {Ag}^{0} + \frac{1}{2} {O}_{2}$ and the silver atoms Ag⁰ generated from the decomposition. Therefore, in order to prevent Ag⁰ generated from the decomposition of Ag₂O from causing erosion and damage to the noble metal container used for mixing and melting the raw materials, the present disclosure adopts raw material components other than Ag₂O that can provide an oxygen atmosphere for melting, to inhibit the conversion of Ag₂O to Ag⁰; preferably, the raw material components capable of providing an oxygen atmosphere comprise nitrates and/or pentavalent antimony salts, etc. Specifically, nitrates are used as raw material components, comprising NaNO_{3.}, KNO₃, AgNO₃, etc. Nitrates decompose to produce O₂ during the melting process, with specific reactions as follows, thereby providing an oxidizing atmosphere that can inhibit the decomposition of Ag₂O. ${NaNO}_{3} - \to {Na}_{2} O + \frac{1}{2} {N}_{2} ↑ + \frac{3}{2} {O}_{2} ↑$ ${KNO}_{3} - \to {K}_{2} O + \frac{1}{2} {N}_{2} ↑ + \frac{3}{2} {O}_{2} ↑$ ${AgNO}_{3} - \to AgO + \frac{1}{2} {N}_{2} ↑ + \frac{3}{2} {O}_{2} ↑$

In addition, pentavalent antimony salts comprising NaSbO₃, KSbO₃, NH₄SbO₃ and their hydrates can also decompose to produce an oxygen atmosphere during the melting process, thereby inhibiting the conversion of Ag₂O to Ag⁰; taking NaSbO₃ as an example, the specific reaction is as follows:

2NaSbO₃-→Na₂O+Sb₂O₃+O₂↑

Furthermore, the Sb³⁺ generated from the decomposition of antimony salts of Sb⁵⁺ during the melting process can act as a reducing agent, reducing Ce⁴⁺ to Ce³⁺ in the glass, maintaining the effective content of Ce³⁺; and subsequently, in the exposed area of the later-stage photosensitive glass under radiation conditions such as ultraviolet irradiation, Ce³⁺can reduce Ag⁺ to Ag⁰. Ag⁰ serves as a growth center, and after heat treatment, Ag⁰ clusters form crystal nuclei, inducing the precipitation of lithium metasilicate crystals.

By controlling the composition of the photosensitive glass, the present disclosure enables it to ensure that the Ag₂O-containing photosensitive glass remains stable during the melting process, with no Ag⁰ generation, thereby solving the problem of erosion and damage to the noble metal melting container caused by Ag⁰ generated from the decomposition of Ag₂O. Moreover, it also ensures that the exposed area of the photosensitive glass obtained after subsequent radiation treatment and heat treatment forms a non-transparent area, thereby achieving shielding of optical signals in the visible and near-infrared wavelength ranges.

In some embodiments of the present disclosure, a photosensitive glass is provided, comprising the following components: 50 wt% to 60 wt% of silica sand, 15 wt% to 22 wt% of lithium carbonate, 6 wt% to 10 wt% of aluminum hydroxide, 3 wt% to 6 wt% of potassium nitrate, 3 wt% to 6 wt% of sodium nitrate, 3 wt% to 5 wt% of zirconium oxide, 0.3 wt% to 0.6 wt% of silver nitrate, 0.05 wt% to 0.10 wt% of cerium oxide, and a pentavalent antimony salt, based on a mass percentage of each component of a raw material in the photosensitive glass; wherein, calculated as sodium antimonate, a mass percentage of the pentavalent antimony salt in the photosensitive glass is 0.3 wt% to 0.8 wt%.

The main crystal type precipitated during the crystallization process of the photosensitive glass is lithium metasilicate (Li₂SiO₃). The precipitation of Li₂SiO₃ is beneficial for reducing the optical transmittance of the exposed area of the photosensitive glass and is advantageous for the shielding of optical signals by the photosensitive glass in the visible and near-infrared wavelength ranges. In the present disclosure, SiO₂ is a glass-forming oxide, constituting as the network skeleton of the glass, and it is derived from silica sand. In some embodiments of the present disclosure, the content of silica sand is 53 wt% to 60 wt%, preferably 53 wt% to 59 wt%, and more preferably 54.00 wt% to 58.96 wt%, based on the mass percentage of each component of the raw material in the photosensitive glass.

In some embodiments of the present disclosure, the content of silica sand may be 53 wt%, 53.5 wt%, 54 wt%, 54.5 wt%, 55 wt%, 55.5 wt%, 56 wt%, 56.5 wt%, 57 wt%, 57.5 wt%, 58 wt%, 58.5 wt%, 58.96 wt%, 59 wt%, or 60 wt%, or a value within a numerical range formed by any two of the above specific values as endpoints, based on the mass percentage of each component of the raw material in the photosensitive glass. It should be understood that, in embodiments, any of the above ranges can be combined with any other range.

In some embodiments of the present disclosure, the mass percentage of lithium carbonate is 15 wt% to 22 wt%, preferably 15 wt% to 20 wt%, and more preferably 17 wt% to 20 wt%, based on the mass percentage of each component of the raw material in the photosensitive glass. In some embodiments of the present disclosure, the content of lithium carbonate may be 15 wt%, 16 wt%, 17 wt%, 17.43 wt%, 17.5 wt%, 18 wt%, 18.5 wt%, 19 wt%, 19.5 wt%, 19.94 wt%, 20 wt%, 21 wt%, or 22 wt%, or a value within a numerical range formed by any two of the above specific values as endpoints, based on the mass percentage of each component of the raw material in the photosensitive glass. It should be understood that, in embodiments, any of the above ranges can be combined with any other range.

In the present disclosure, Al₂O₃ acts as a glass network intermediate, entering the glass network structure as [AlO₄] tetrahedra. Aluminum oxide can increase the stability of the photosensitive glass, and it is derived from aluminum hydroxide. In some embodiments of the present disclosure, the content of aluminum hydroxide is 6 wt% to 10 wt%, preferably 8 wt% to 10 wt%, and more preferably 8.22 wt% to 9.97 wt%, based on the mass percentage of each component of the raw material in the photosensitive glass. In some embodiments of the present disclosure, the content of aluminum hydroxide may be 6 wt%, 7 wt%, 8 wt%, 8.22 wt%, 8.5 wt%, 8.7 wt%, 9 wt%, 9.2 wt%, 9.5 wt%, 9.7 wt%, 9.97 wt%, or 10 wt%, or a value within a numerical range formed by any two of the above specific values as endpoints, based on the mass percentage of each component of the raw material in the photosensitive glass. It should be understood that, in embodiments, any of the above ranges can be combined with any other range.

In the present disclosure, zirconium oxide (ZrO₂) can improve the chemical stability of the photosensitive glass. However, ZrO₂ has a high melting point, when the addition amount is too high, it can cause the melting temperature of the photosensitive glass to increase. In some embodiments of the present disclosure, the content of zirconium oxide is 3 wt% to 5 wt%, preferably 3.33 wt% to 5 wt%, and more preferably 3.33 wt% to 4.96 wt%, based on the mass percentage of each component of the raw material in the photosensitive glass. In some embodiments of the present disclosure, the content of zirconium oxide may be 3.0 wt%, 3.2 wt%, 3.33 wt%, 3.5 wt%, 3.7 wt%, 4.0 wt%, 4.2 wt%, 4.5 wt%, 4.8 wt%, 4.96 wt%, or 5.0 wt%, or a value within a numerical range formed by any two of the above specific values as endpoints, based on the mass percentage of each component of the raw material in the photosensitive glass. It should be understood that, in embodiments, any of the above ranges can be combined with any other range.

In the present disclosure, Na₂O and K₂O are glass network exo-oxide, serving as fluxing agents, and can reduce the melting temperature of the glass. In the presence of Na⁺ and K⁺, Na⁺ and K⁺ preferentially enter the aluminum-silicon-oxygen network to compensate for the charge, to some extent maintaining the lithium content in the lithium-rich area, making the Si/Li ratio in the lithium-rich area closer to the chemical ratio of Li₂SiO₃. Thus, the photosensitive glass comprising Na₂O and K₂O exhibits a precipitated crystalline phase of lithium metasilicate; and Na₂O is derived from sodium nitrate, and K₂O is derived from potassium nitrate. In the present disclosure, nitrates such as sodium nitrate, potassium nitrate, and/or silver nitrate combined with antimonate have a better clarifying effect, which in turn affects the transmittance and other properties of the final product. Carbonates cannot achieve the transmittance effect of the final product involved in the present disclosure.

In some embodiments of the present disclosure, the content of sodium nitrate is 3.0 wt% to 6.0 wt%, preferably 3.5 wt% to 5.5 wt%, and more preferably 3.77 wt% to 5.45 wt%, based on the mass percentage of each component of the raw material in the photosensitive glass. In some embodiments of the present disclosure, the content of sodium nitrate may be 3.0 wt%, 3.5 wt%, 3.77 wt%, 4.0 wt%, 4.2 wt%, 4.5 wt%, 4.8 wt%, 5 wt%, 5.3 wt%, 5.45 wt%, or 5.5 wt%, or a value within a numerical range formed by any two of the above specific values as endpoints, based on the mass percentage of each component of the raw material in the photosensitive glass. It should be understood that, in embodiments, any of the above ranges can be combined with any other range.

In some embodiments of the present disclosure, the content of potassium nitrate is 3 wt% to 6 wt%, preferably 4 wt% to 6 wt%, and more preferably 4.07 wt% to 5.97 wt%, based on the mass percentage of each component of the raw material in the photosensitive glass. In some embodiments of the present disclosure, the content of potassium nitrate may be 3.0 wt%, 4.0 wt%, 4.07 wt%, 4.2 wt%, 4.5 wt%, 4.7 wt%, 5.0 wt%, 5.2 wt%, 5.5 wt%, 5.8 wt%, 5.97 wt%, or 6.0 wt%, or a value within a numerical range formed by any two of the above specific values as endpoints, based on the mass percentage of each component of the raw material in the photosensitive glass. It should be understood that, in embodiments, any of the above ranges can be combined with any other range.

In some embodiments of the present disclosure, the content of silver nitrate is 0.3 wt% to 0.6 wt%, preferably 0.30 wt% to 0.5 wt%, and more preferably 0.32 wt% to 0.49 wt%, based on the mass percentage of each component of the raw material in the photosensitive glass. In some embodiments of the present disclosure, the content of silver nitrate may be 0.30 wt%, 0.32 wt%, 0.35 wt%, 0.37 wt%, 0.40 wt%, 0.43 wt%, 0.45 wt%, 0.49 wt%, 0.50 wt%, or 0.60 wt%, or a value within a numerical range formed by any two of the above specific values as endpoints, based on the mass percentage of each component of the raw material in the photosensitive glass. It should be understood that, in embodiments, any of the above ranges can be combined with any other range.

Cerium oxide (CeO₂) is a photosensitizer. In the UV exposed process, it provides electrons to Ag⁺. In some embodiments of the present disclosure, the content of cerium oxide is 0.05 wt% to 0.10 wt%, preferably 0.05 wt% to 0.09 wt%, and more preferably 0.06 wt% to 0.09 wt%, based on the mass percentage of each component of the raw material in the photosensitive glass. In some embodiments of the present disclosure, the content of cerium oxide may be 0.05 wt%, 0.06 wt%, 0.07 wt%, 0.08 wt%, 0.09 wt%, or 0.10 wt%, or a value within a numerical range formed by any two of the above specific values as endpoints, based on the mass percentage of each component of the raw material in the photosensitive glass. It should be understood that, in embodiments, any of the above ranges can be combined with any other range.

In some embodiments of the present disclosure, to ensure a sufficient amount of Sb⁵⁺, in the present disclosure, calculated as sodium antimonate, the content of the pentavalent antimony salt is 0.3 wt% to 0.8 wt%, preferably 0.31 wt% to 0.5 wt%, and more preferably 0.31 wt% to 0.49 wt%, based on the mass percentage of each component of the raw material in the photosensitive glass.

In some embodiments of the present disclosure, calculated as sodium antimonate, the content of the pentavalent antimony salt may be 0.30 wt%, 0.31 wt%, 0.33 wt%, 0.35 wt%, 0.38 wt%, 0.40 wt%, 0.43 wt%, 0.45 wt%, 0.48 wt%, 0.49 wt%, or 0.50 wt%, or a value within a numerical range formed by any two of the above specific values as endpoints, based on the mass percentage of each component of the raw material in the photosensitive glass. It should be understood that, in embodiments, any of the above ranges can be combined with any other range.

It should be noted that the pentavalent antimony salt includes but is not limited to sodium antimonate, potassium antimonate, ammonium antimonate, and/or a hydrate thereof. Different types of pentavalent antimony salts in the present disclosure are all converted based on sodium antimonate.

In some embodiments of the present disclosure, the pentavalent antimony salt comprises at least one selected from the group consisting of NaSbO₃, KSbO₃, NH₄SbO₃ and a hydrate thereof.

In the present disclosure, the photosensitive glass comprises an exposed area and a non-exposed area. The exposed area has low transmittance in the visible and near-infrared wavelength ranges, and the non-exposed area has high transmittance in the visible and near-infrared wavelength ranges. In some embodiments of the present disclosure, when the thickness of the photosensitive glass is 0.40 mm to 1.00 mm, a transmittance T₁ of the exposed area of the photosensitive glass at a wavelength of 850 nm is 0.00% to 5.00%, preferably the transmittance T₁ is 0.00% to 3.00%. In some embodiments of the present disclosure, when the thickness of the photosensitive glass is 0.40 mm to 1.00 mm, the transmittance T₁ of the exposed area of the photosensitive glass at a wavelength of 850 nm may be 0.00%, 0.22%, 0.50%, 0.88%, 0.96%, 1.00%, 1.27%, 1.55%, 1.59%, 1.64%, 2.00%, 2.30%, 2.51%, 3.00%, 3.50%, 4.00%, 4.50%, 4.80%, or 5.00%; or a value within a numerical range formed by any two of the above specific values as endpoints. It should be understood that, in embodiments, any of the above ranges can be combined with any other range.

In some embodiments of the present disclosure, when the thickness of the photosensitive glass is 0.40 mm to 1.00 mm, a transmittance T₂ of the exposed area of the photosensitive glass at a wavelength of 550 nm is 0.00% to 5.00%, preferably the transmittance T₂ is 0.00% to 2.00%. In some embodiments of the present disclosure, when the thickness of the photosensitive glass is 0.40 mm to 1.00 mm, the transmittance T₂ of the exposed area of the photosensitive glass at a wavelength of 550 nm may be 0.00%, 0.20%, 0.50%, 0.70%, 0.90%, 1.00%, 1.35%, 1.50%, 1.70%, 2.00%, 2.50%, 3.00%, 3.50%, 4.00%, 4.20%, 4.50%, 4.90%, or 5.00%; or a value within a numerical range formed by any two of the above specific values as endpoints. It should be understood that, in embodiments, any of the above ranges can be combined with any other range.

In some embodiments of the present disclosure, when the thickness of the photosensitive glass is 0.40 mm to 1.00 mm, a transmittance T₃ of the non-exposed area of the photosensitive glass at a wavelength of 850 nm is more than or equal to 90%. In some embodiments of the present disclosure, when the thickness of the photosensitive glass is 0.40 mm to 1.00 mm, the transmittance T₃ of the non-exposed area of the photosensitive glass at a wavelength of 850 nm may be 90.00%, 90.50%, 91.00%, 91.69%, 91.92%, 92.03%, 92.21%, 93.00%, 93.50%, 94.00%, 94.80%, or 95.00%; or a value within a numerical range formed by any two of the above specific values as endpoints. It should be understood that, in embodiments, any of the above ranges can be combined with any other range.

In some embodiments of the present disclosure, when the thickness of the photosensitive glass is 0.40 mm to 1.00 mm, a transmittance T₄ of the non-exposed area of the photosensitive glass at a wavelength of 550 nm is more than or equal to 90%. In some embodiments of the present disclosure, when the thickness of the photosensitive glass is 0.40 mm to 1.00 mm, the transmittance T₄ of the non-exposed area of the photosensitive glass at a wavelength of 550 nm may be 90.00%, 90.74%, 91.05%, 91.60%, 92.03%, 92.50%, 93.00%, 93.50%, 94.00%, 94.80%, or 95.00%; or a value within a numerical range formed by any two of the above specific values as endpoints. It should be understood that, in embodiments, any of the above ranges can be combined with any other range.

In some embodiments of the present disclosure, a preparation method for the above photosensitive glass is provided, comprising:
proportioning each component of the raw material, then mixing and melting in a noble metal container, followed by molding, and then performing annealing treatment to obtain a substrate glass;
the substrate glass comprises a first area and a second area, performing masking treatment on the first area, the second area not being subjected to masking treatment, to obtain a masked substrate glass; and
after performing radiation treatment and heat treatment on the masked substrate glass, obtaining the photosensitive glass having the non-exposed area and the exposed area; wherein the non-exposed area corresponds to the first area, and the exposed area corresponds to the second area.

In the present disclosure, the container includes but is not limited to crucibles, furnaces, channels, etc. The noble metal container refers to a container where at least the part in contact with the raw materials is made of noble metal. The noble metal includes but is not limited to gold, platinum, rhodium, etc. In some embodiments of the present disclosure, the noble metal container is a container prepared using at least one metal comprising gold, platinum, and rhodium.

In the present disclosure, existing molding methods in the prior art can be used to prepare the substrate glass, and the present disclosure imposes no limitation on this. For example, the molding method for the substrate glass may include but is not limited to float process, overflow down-draw, drawing, rolling, or casting process.

By way of example, according to the specified raw materials and corresponding weight fractions, the ingredients were proportioned. After the raw materials were mixed uniformly, they were fed into the noble metal container in stages and continuously for melting. The feeding method could be adjusted according to the different noble metal containers. After the glass melting was completed, it was formed into glass bricks. Then, the glass bricks were transferred to an annealing furnace for annealing treatment. After annealing was completed, natural cooling to room temperature yielded the substrate glass.

In some embodiments of the present disclosure, the composition of the substrate glass of the present disclosure is the same as or basically the same as the composition of the photosensitive glass; the specific composition is as before.

In some embodiments of the present disclosure, the temperature of the melting is 1400°C to 1650°C, and the time of the melting is 6 hours to 48 hours. In some embodiments of the present disclosure, the temperature of the melting may be 1400 °C, 1475 °C, 1500 °C, 1525 °C, 1550 °C, 1575 °C, 1600 °C, 1625 °C, or 1650°C, or a value within a numerical range formed by any two of the above specific values as endpoints. It should be understood that, in embodiments, any of the above ranges can be combined with any other range.

In some embodiments of the present disclosure, the time of the melting may be any value among 6 h, 9 h, 12 h, 15 h, 18 h, 21 h, 24 h, 27 h, 30 h, 33 h, 36 h, 39 h, 42 h, 45 h, or 48 h, or a value within a numerical range formed by any two of the above specific values as endpoints. It should be understood that, in specific embodiments, any of the above ranges can be combined with any other range, as long as the photosensitive glass with the required properties of the present disclosure can be obtained.

In some embodiments of the present disclosure, the temperature of the annealing is 400°C to 500°C, and the time of the annealing is 8 hours to 24 hours. In some embodiments of the present disclosure, the temperature of the annealing may be 400 °C, 410 °C, 420 °C, 430 °C, 440 °C, 450 °C, 460 °C, 470 °C, 480 °C, 490 °C, or 500°C, or a value within a numerical range formed by any two of the above specific values as endpoints. It should be understood that, in embodiments, any of the above ranges can be combined with any other range.

In some embodiments of the present disclosure, the time of the annealing may be 5 h, 6 h, 7 h, 8 h, 10 h, 12 h, 14 h, 16 h, 18 h, 20 h, 22 h, or 24 h, or a value within a numerical range formed by any two of the above specific values as endpoints. It should be understood that, in embodiments, any of the above ranges can be combined with any other range.

In some embodiments of the present disclosure, the masking treatment comprises masking using a masking ink and/or a mask plate.

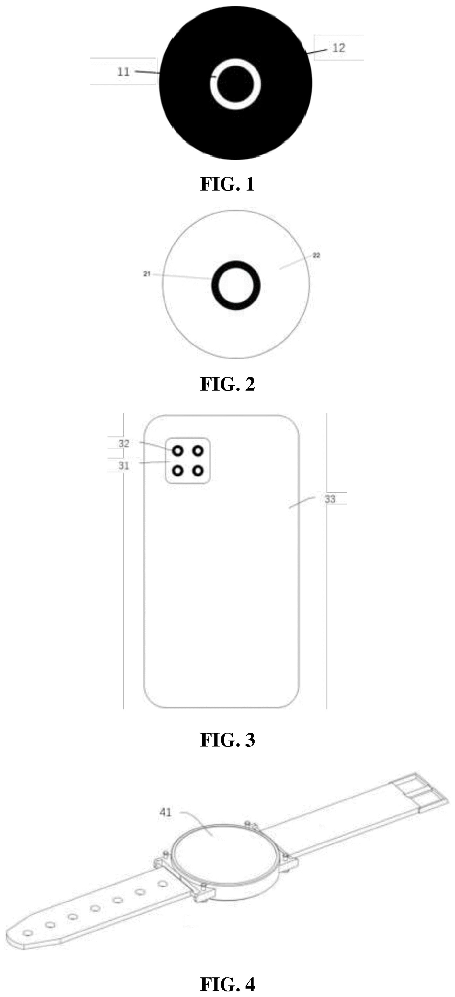

By way of example, a structural schematic diagram of the substrate glass after masking using a masking ink is shown in FIG. 1. The composite circular hole has a light-transmitting area 11 corresponding to the inner diameter and a light-blocking area 12 corresponding to the area other than the inner diameter. The corresponding formed schematic structural diagram of the photosensitive glass is shown in FIG. 2. The position corresponding to the light-transmitting area 11 forms the exposed area 21, and the position corresponding to the light-blocking area 12 forms the non-exposed area 22.

In some embodiments of the present disclosure, the radiation treatment comprises ultraviolet irradiation treatment.

In some embodiments of the present disclosure, the wavelength of the ultraviolet irradiation treatment is 300 nm to 320 nm, the intensity of the ultraviolet irradiation treatment is 20 mW/cm² to 360 mW/cm², and the time of the ultraviolet irradiation treatment is 5 min to 60 min.

In some embodiments of the present disclosure, the wavelength of the ultraviolet irradiation treatment is 300 nm, 302 nm, 305 nm, 308 nm, 310 nm, 312 nm, 315 nm, 317 nm, or 320 nm, or a value within a numerical range formed by any two of the above specific values as endpoints. In some embodiments of the present disclosure, the intensity of the ultraviolet irradiation treatment is 20 mW/cm², 40 mW/cm², 60 mW/cm², 80 mW/cm², 100 mW/cm², 120 mW/cm², 140 mW/cm², 160 mW/cm², 180 mW/cm², 200 mW/cm², 210 mW/cm², 220 mW/cm², 230 mW/cm², 240 mW/cm², 250 mW/cm², 260 mW/cm², 270 mW/cm², 280 mW/cm², 290 mW/cm², 300 mW/cm², 310 mW/cm², 320 mW/cm², 330 mW/cm², 340 mW/cm², 350 mW/cm², or 360 mW/cm², or a value within a numerical range formed by any two of the above specific values as endpoints. In some embodiments of the present disclosure, the time of the ultraviolet irradiation treatment is 5 min, 10 min, 15 min, 20 min, 25 min, 30 min, 35 min, 40 min, 45 min, 50 min, 55 min, or 60 min, or a value within a numerical range formed by any two of the above specific values as endpoints; as long as the photosensitive glass with the required properties of the present disclosure can be obtained. It should be understood that, in specific embodiments, any of the above ranges can be combined with any other range, as long as the photosensitive glass with the required properties of the present disclosure can be obtained.

In some embodiments of the present disclosure, the heat treatment comprises nucleation treatment and crystallization treatment. Nucleation treatment and crystallization treatment are common processes in the art.

In some embodiments of the present disclosure, the heating rate for the nucleation treatment is 1 C/min to 10 °C/min. In some embodiments of the present disclosure, the time of the nucleation treatment may be 1 C/min, 2 °C/min, 3 °C/min, 4 C/min, 5 °C/min, 6 °C/min, 7 °C/min, 8 °C/min, 9 °C/min, or 10 °C/min, or a value within a numerical range formed by any two of the above specific values as endpoints. In some embodiments of the present disclosure, the temperature of the nucleation treatment may be 430 °C to 500 °C. In some embodiments of the present disclosure, the temperature of the nucleation treatment may be 430 °C, 440 °C, 450 °C, 460 °C, 470 C, 480 °C, 490 °C, or 500 °C, or a value within a numerical range formed by any two of the above specific values as endpoints. In some embodiments of the present disclosure, the time of the nucleation treatment is 30 min to 360 min. In some embodiments of the present disclosure, the time of the nucleation treatment may be 30 min, 45 min, 50 min, 55 min, 60 min, 90 min, 100 min, 120 min, 140 min, 150 min, 160 min, 170 min, 180 min, 190 min, 200 min, 220 min, 240 min, 280 min, 300 min, 320 min, 340 min, or 360 min, or a value within a numerical range formed by any two of the above specific values as endpoints.

In the present disclosure, the crystallization treatment comprises one-step crystallization treatment and multi-step crystallization treatment. In some embodiments of the present disclosure, the heating rate for the crystallization treatment is 1 °C/min to 10 °C/min. In some embodiments of the present disclosure, the time of the crystallization treatment may be 1 °C/min, 2 C/min, 3 °C/min, 4 °C/min, 5 °C/min, 6 °C/min, 7 °C/min, 8 °C/min, 9 °C/min, or 10 °C/min, or a value within a numerical range formed by any two of the above specific values as endpoints.

In some embodiments of the present disclosure, the temperature of one-step crystallization treatment may be 500 °C to 800 °C. In some embodiments of the present disclosure, the temperature of one-step crystallization treatment may be 500 °C, 510 °C, 520 °C, 530 °C, 540 °C, 550 °C, 560 °C, 570 °C, 580 °C, 600 °C, 650 °C, 700 °C, 750 °C, or 800 °C, or a value within a numerical range formed by any two of the above specific values as endpoints. In some embodiments of the present disclosure, the time of one-step crystallization treatment is 30 min to 480 min. In some embodiments of the present disclosure, the time of crystallization treatment may be 30 min, 45 min, 50 min, 55 min, 60 min, 90 min, 100 min, 120 min, 140 min, 150 min, 160 min, 170 min, 180 min, 190 min, 200 min, 220 min, 240 min, 280 min, 300 min, 340 min, 380 min, 400 min, 430 min, 450 min, or 480 min, or a value within a numerical range formed by any two of the above specific values as endpoints.

In some embodiments of the present disclosure, multi-step crystallization treatment comprises two-step crystallization treatment. In some embodiments of the present disclosure, in the two-step crystallization treatment, the temperature of the first step of crystallization treatment is 500 °C to 560 °C, and the temperature of the second step of crystallization treatment is 560 °C to 800 °C. It can be understood that the temperature of the second step of crystallization treatment is higher than that for the first step of crystallization treatment.

In some embodiments of the present disclosure, in the two-step crystallization treatment, the temperature of the first step of crystallization treatment may be 500°C, 510 °C, 520 °C, 530 °C, 540 °C, 550 °C, or 560 °C, or a value within a numerical range formed by any two of the above specific values as endpoints. In some embodiments of the present disclosure, in the two-step crystallization treatment, the temperature of the second step of crystallization treatment may be 560 °C, 570 °C, 580 °C, 600 °C, 650 °C, 700 °C, 750 °C, or 800 °C, or a value within a numerical range formed by any two of the above specific values as endpoints.

In some embodiments of the present disclosure, in the two-step crystallization treatment, the time of the first step of crystallization treatment is 30 min to 240 min, and the time of the second step of crystallization treatment is 30 min to 240 min. In some embodiments of the present disclosure, in the two-step crystallization treatment, the time of the first step of crystallization treatment may be 30 min, 45 min, 50 min, 55 min, 60 min, 90 min, 100 min, 120 min, 140 min, 150 min, 160 min, 170 min, 180 min, 190 min, 200 min, 220 min, or 240 min, or a value within a numerical range formed by any two of the above specific values as endpoints. In some embodiments of the present disclosure, in the two-step crystallization treatment, the time of the second step of crystallization treatment may be 30 min, 45 min, 50 min, 55 min, 60 min, 90 min, 100 min, 120 min, 140 min, 150 min, 160 min, 170 min, 180 min, 190 min, 200 min, 220 min, or 240 min, or a value within a numerical range formed by any two of the above specific values as endpoints.

Before and/or after the heat treatment, those skilled in the art may also perform other conventional steps to obtain photosensitive glass samples that meet the required specifications or requirements, for example, shaping treatment, cutting treatment (e.g., using a multi-wire saw for cutting), CNC machining treatment (computer numerical control), thinning treatment, or polishing treatment steps, etc. There is no limitation in the present disclosure on the dimensional processing of the photosensitive glass, for example, it may be 50 mm × 50 mm × 1.0 mm, 300 mm × 120 mm × 0.7 mm, etc.

In some embodiments of the present disclosure, the thickness of the substrate glass and/or the photosensitive glass of the present disclosure is not particularly limited, for example, it may be 0.4 mm to 2.0 mm. In some embodiments of the present disclosure, the thickness of the photosensitive glass of the present disclosure may be 0.4 mm, 0.5 mm, 0.6 mm, 0.7 mm, 0.8 mm, 0.9 mm, 1.0 mm, 1.2 mm, 1.4 mm, 1.6 mm, 1.8 mm, or 2.0 mm, or a value within a numerical range formed by any two of the above specific values as endpoints. It should be understood that, in embodiments, any of the above ranges can be combined with any other range.

In some embodiments of the present disclosure, a strengthened photosensitive glass is provided, comprising a strengthening layer and a tensile stress layer, wherein the strengthening layer extends inward from the surface of the strengthened photosensitive glass, a thickness of the strengthened photosensitive glass is t, and the thickness of the strengthening layer is greater than 0 and less than or equal to 0.22 t.

The tensile stress layer and/or a center of the strengthened photosensitive glass comprises the following components:
SiO₂: 65.00% to 74.00%, Al₂O₃: 5.00% to 10.00%, Li₂O: 7.90% to 12.00%, Na₂O: 1.00% to 3.00%, K₂O: 1.50% to 3.80%, ZrO₂: 3.50% to 6.50%, Ag₂O: 0.20% to 0.50%, CeO₂: 0.07% to 0.13% and Sb₂O₃: 0.20% to 0.50%, based on the mass percentage of oxides;
the strengthening layer comprises the following components:
   SiO₂: 65.00% to 74.00%, Al₂O₃: 5.00% to 10.00%, Na₂O: 4.00% to 16.00%, K₂O: 2.0% to 5.0%, ZrO₂: 3.50% to 6.50%, Ag₂O: 0.20% to 0.50%, CeO₂: 0.07% to 0.13% and Sb₂O₃: 0.20% to 0.50%, based on the mass percentage of oxides; the content of Li₂O in the strengthening layer is lower than the content of Li₂O in the tensile stress layer and/or at the center of the strengthened photosensitive glass;
   wherein, Na₂O is obtained from sodium nitrate, K₂O is obtained from potassium nitrate, Ag₂O is obtained from silver nitrate, and Sb₂O₃ is obtained from a pentavalent antimony salt;
   the strengthened photosensitive glass comprises a non-exposed area and an exposed area.

In some embodiments of the present disclosure, a strengthened photosensitive glass is provided, having a thickness of t, which is obtained by chemical strengthening of the photosensitive glass according to any one of the above embodiments.

In some embodiments of the present disclosure, the above strengthened photosensitive glass comprises a strengthening layer and a tensile stress layer. The strengthening layer comprises the following components:
SiO₂: 65.00% to 74.00%, Al₂O₃: 5.00% to 10.00%, Na₂O: 4.00% to 16.00%, K₂O: 2.0% to 5.0%, ZrO₂: 3.50% to 6.50%, Ag₂O: 0.20% to 0.50%, CeO₂: 0.07% to 0.13% and Sb₂O₃: 0.20% to 0.50%, based on the mass percentage of oxides; the content of Li₂O in the strengthening layer is lower than the content of Li₂O in the tensile stress layer and/or at the center of the strengthened photosensitive glass;
wherein, Na₂O is obtained from sodium nitrate, K₂O is obtained from potassium nitrate, Ag₂O is obtained from silver nitrate, and Sb₂O₃ is obtained from a pentavalent antimony salt;
the tensile stress layer and/or the center of the strengthened photosensitive glass comprises the following components:
   SiO₂: 65.00% to 74.00%, Al₂O₃: 5.00% to 10.00%, Li₂O: 7.90% to 12.00%, Na₂O: 1.00% to 3.00%, K₂O: 1.50% to 3.80%, ZrO₂: 3.50% to 6.50%, Ag₂O: 0.20% to 0.50%, CeO₂: 0.07% to 0.13% and Sb₂O₃: 0.20% to 0.50%, based on the mass percentage of oxides.

In the present disclosure, SiO₂ is a glass-forming oxide, forming an irregular continuous network with structural units of silicon-oxygen tetrahedra, which is the skeleton of the glass. In some embodiments of the present disclosure, the content of SiO₂ in the strengthening layer or in the tensile stress layer or at the center of the strengthened photosensitive glass is 65.00% to 74.00%, preferably 66.00% to 73.20%, based on the mass percentage of oxides.

In some embodiments of the present disclosure, the content of SiO₂ in the strengthening layer or in the tensile stress layer or at the center of the strengthened photosensitive glass may be 65.00%, 66.00%, 67.00%, 68.00%, 69.00%, 70.00%, 71.00%, 72.00%, 73.00%, or 74.00%, or a value within a numerical range formed by any two of the above specific values as endpoints, based on the mass percentage of oxides. It should be understood that, in embodiments, any of the above ranges can be combined with any other range.

In the present disclosure, Al₂O₃ is a glass network intermediate, entering the glass network structure as [AlO₄] tetrahedra. An increase in Al₂O₃ can increase the T_{g} temperature of the glass, enhance thermal stability, and facilitate to suppress phase separation during the heat treatment process of the glass. But excessive Al₂O₃ can increase the melting temperature of the glass. In some embodiments of the present disclosure, the content of Al₂O₃ in the strengthening layer or in the tensile stress layer or at the center of the strengthened photosensitive glass is 5.00% to 10.00%, preferably 5.10% to 9.70%, and more preferably 5.20% to 9.40%, based on the mass percentage of oxides.

In some embodiments of the present disclosure, the content of Al₂O₃ in the strengthening layer or in the tensile stress layer or at the center of the strengthened photosensitive glass may be 5.00%, 5.50%, 6.00%, 6.50%, 7.00%, 7.50%, 8.00%, 8.50%, 9.00%, 9.50%, 10.00%, 7.25%, 5.83%, 8.76%, 7.62%, 7.89%, 6.47%, or 8.96%, or a value within a numerical range formed by any two of the above specific values as endpoints, based on the mass percentage of oxides. It should be understood that, in embodiments, any of the above ranges can be combined with any other range.

In some embodiments of the present disclosure, the content of Li₂O in the strengthening layer of the strengthened photosensitive glass is 7.90% to 12.00%, based on the mass percentage of oxides.

In some embodiments of the present disclosure, the content of Li₂O in the strengthening layer or at the center of the strengthened photosensitive glass may be 7.90%, 8.00%, 8.50%, 9.00%, 9.50%, 10.00%, 10.50%, 11.00%, 11.50%, or 12.00%, or a value within a numerical range formed by any two of the above specific values as endpoints, based on the mass percentage of oxides. It should be understood that, in embodiments, any of the above ranges can be combined with any other range.

In some embodiments of the present disclosure, the content of Li₂O in the strengthening layer is lower than that in the tensile stress layer and/or at the center of the strengthened photosensitive glass, based on the mass percentage of oxides.

In some embodiments of the present disclosure, the content of Na₂O in the tensile stress layer or at the center of the strengthened photosensitive glass is 1.00% to 3.00%, preferably 1.00% to 2.80%, based on the mass percentage of oxides. In some embodiments of the present disclosure, the content of Na₂O in the tensile stress layer or at the center of the strengthened photosensitive glass may be 1.00%, 1.10%, 1.20%, 1.30%, 1.40%, 1.50%, 1.60%, 1.70%, 1.80%, 1.90%, 2.00%, 2.10%, 2.20%, 2.30%, 2.40%, 2.50%, 2.60%, 2.70%, 2.80%, 2.90%, or 3.00%, or a value within a numerical range formed by any two of the above specific values as endpoints, based on the mass percentage of oxides. It should be understood that, in embodiments, any of the above ranges can be combined with any other range.

In some embodiments of the present disclosure, the content of Na₂O in the strengthening layer of the strengthened photosensitive glass is 4.00% to 16.00%, preferably 4.00% to 15.00%, based on the mass percentage of oxides. In some embodiments of the present disclosure, the content of Na₂O in the strengthening layer of the strengthened photosensitive glass may be 4.00%, 4.50%, 4.80%, 5.00%, 5.40%, 5.80%, 6.60%, 6.90%, 7.00%, 7.20%, 7.80%, 8.00%, 8.50%, 8.90%, 9.00%, 9.50%, 10.0%, 10.30%, 10.80%, 11.00%, 11.50%, 12.00%, 12.50%, 12.90%, 13.00%, 13.50%, 14.00%, 14.50%, 15.00%, 15.60%, 15.90%, or 16.00%, or a value within a numerical range formed by any two of the above specific values as endpoints, based on the mass percentage of oxides. It should be understood that, in embodiments, any of the above ranges can be combined with any other range.

In some embodiments of the present disclosure, the content of K₂O in the tensile stress layer or at the center of the strengthened photosensitive glass is 1.50% to 3.80%, preferably 1.80% to 3.50%, based on the mass percentage of oxides. In some embodiments of the present disclosure, the content of K₂O in the tensile stress layer or at the center of the strengthened photosensitive glass may be 1.50%, 1.80%, 2.00%, 2.30%, 2.40%, 2.80%, 3.00%, 3.30%, 3.40%, 3.50%, 3.60%, 3.70%, or 3.80%, or a value within a numerical range formed by any two of the above specific values as endpoints, based on the mass percentage of oxides. It should be understood that, in embodiments, any of the above ranges can be combined with any other range.

In some embodiments of the present disclosure, the content of K₂O in the strengthening layer of the strengthened photosensitive glass is 2.00% to 5.00%, preferably 2.20% to 4.90%, based on the mass percentage of oxides. In some embodiments of the present disclosure, the content of K₂O in the strengthening layer of the strengthened photosensitive glass may be 2.00%, 2.50%, 2.80%, 3.00%, 3.40%, 3.80%, 4.00%, 4.30%, 4.80%, or 5.00%, or a value within a numerical range formed by any two of the above specific values as endpoints, based on the mass percentage of oxides. It should be understood that, in embodiments, any of the above ranges can be combined with any other range.

In some embodiments of the present disclosure, the content of ZrO₂ in the strengthening layer or in the tensile stress layer or at the center of the strengthened photosensitive glass is 3.50% to 6.50%, preferably 3.80% to 6.40%, based on the mass percentage of oxides. In some embodiments of the present disclosure, the content of ZrO₂ in the strengthening layer or in the tensile stress layer or at the center of the strengthened photosensitive glass may be 3.50%, 3.80%, 4.00%, 4.30%, 4.80%, 5.00%, 5.30%, 5.70%, 5.80%, 5.90%, 6.00%, 6.20%, or 6.50%, or a value within a numerical range formed by any two of the above specific values as endpoints, based on the mass percentage of oxides. It should be understood that, in embodiments, any of the above ranges can be combined with any other range.

In some embodiments of the present disclosure, the content of Ag₂O in the strengthening layer or in the tensile stress layer or at the center of the strengthened photosensitive glass is 0.20% to 0.50%, preferably 0.20% to 0.49%, based on the mass percentage of oxides. In some embodiments of the present disclosure, the content of Ag₂O in the strengthening layer or in the tensile stress layer or at the center of the strengthened photosensitive glass may be 0.20%, 0.22%, 0.24%, 0.26%, 0.28%, 0.30%, 0.32%, 0.34%, 0.36%, 0.38%, 0.40%, 0.42%, 0.44%, 0.46%, 0.48%, or 0.50%, or a value within a numerical range formed by any two of the above specific values as endpoints, based on the mass percentage of oxides. It should be understood that, in embodiments, any of the above ranges can be combined with any other range.

In some embodiments of the present disclosure, the mass percentage of CeO₂ in the strengthening layer or in the tensile stress layer or at the center of the strengthened photosensitive glass is 0.07% to 0.13%, preferably 0.08% to 0.12%, based on the mass percentage of oxides.

In some embodiments of the present disclosure, the content of CeO₂ in the strengthening layer or in the tensile stress layer or at the center of the strengthened photosensitive glass may be 0.07%, 0.08%, 0.09%, 0.10%, 0.11%, 0.12%, or 0.13%, or a value within a numerical range formed by any two of the above specific values as endpoints, based on the mass percentage of oxides. It should be understood that, in embodiments, any of the above ranges can be combined with any other range.

In the present disclosure, Sb₂O₃ is a weak reducing agent and also acts as a clarifying agent. Sb³⁺ undergoes a redox reaction with Ce⁴⁺ during the glass melting process, maintaining the effective content of Ce³⁺. In some embodiments of the present disclosure, the mass percentage of Sb₂O₃ in the strengthening layer or in the tensile stress layer or at the center of the strengthened photosensitive glass is 0.20% to 0.50%, preferably 0.22% to 0.49%, based on the mass percentage of oxides.

In some embodiments of the present disclosure, the content of Sb₂O₃ in the strengthening layer or in the tensile stress layer or at the center of the strengthened photosensitive glass may be 0.20%, 0.22%, 0.25%, 0.28%, 0.30%, 0.34%, 0.37%, 0.39%, 0.40%, 0.42%, 0.45%, 0.47%, 0.49%, or 0.50%, or a value within a numerical range formed by any two of the above specific values as endpoints, based on the mass percentage of oxides. It should be understood that, in embodiments, any of the above ranges can be combined with any other range.

In the present disclosure, chemical strengthening can be performed by existing known methods; for example, chemical strengthening comprises single-step chemical strengthening or multi-step chemical strengthening.

In some embodiments of the present disclosure, single-step chemical strengthening uses a salt bath containing NaNO₃; preferably the content of NaNO₃ in the salt bath is 30 wt% to 100 wt%; preferably, single-step chemical strengthening uses a mixed salt bath containing NaNO₃ and KNO₃, preferably the content of KNO₃ in the mixed salt bath is greater than or equal to 80 wt% and less than 100 wt%, and the content of NaNO₃ is greater than 0 and less than or equal to 20 wt%.

In some embodiments of the present disclosure, the temperature of single-step chemical strengthening is 380 °C to 480 °C; preferably, the ion exchange time of single-step chemical strengthening is 5 hours to 20 hours.

In some embodiments of the present disclosure, multi-step chemical strengthening comprises two-step chemical strengthening, wherein, the first step of chemical strengthening uses a salt bath containing NaNO₃, preferably the content of NaNO₃ is 30 wt% to 100 wt%; the second step of chemical strengthening uses a salt bath containing KNO₃, preferably the content of KNO₃ is 60 wt% to 100 wt%.

In some embodiments of the present disclosure, the temperature of the first step of chemical strengthening is 380 °C to 480 °C, preferably the time of the first step of chemical strengthening is 3 hours to 20 hours; and/or the temperature of the second step of chemical strengthening is 380 °C to 480 °C, preferably the time of the second step of chemical strengthening is 5 minutes to 30 minutes.

In some embodiments of the present disclosure, other conventional processing treatments may be performed on the photosensitive glass before chemical strengthening to obtain photosensitive glass samples that meet the required specifications or requirements, wherein the processing treatments comprise one or more selected from the group consisting of CNC processing, grinding and polishing, cleaning, 3D hot bending, and buffing. It should be noted that there is no limitation in the present disclosure on the dimensional processing of the strengthened photosensitive glass sample, for example, it may be 50 mm × 50 mm × 1.0 mm, 300 mm × 120 mm × 0.7 mm, etc.

In some embodiments of the present disclosure, the strengthened photosensitive glass can be planar or curved.

In some embodiments of the present disclosure, the thickness t of the strengthened photosensitive glass of the present disclosure is not particularly limited, for example, it may be 0.4 mm to 2.0 mm. In some embodiments of the present disclosure, the thickness t of the strengthened photosensitive glass may be 0.4 mm, 0.5 mm, 0.6 mm, 0.7 mm, 0.8 mm, 0.9 mm, 1.0 mm, 1.2 mm, 1.4 mm, 1.6 mm, 1.8 mm, or 2.0 mm, or a value within a numerical range formed by any two of the above specific values as endpoints. It should be understood that, in embodiments, any of the above ranges can be combined with any other range.

In some embodiments of the present disclosure, the surface CS of the non-exposed area of the strengthened photosensitive glass is more than or equal to 300 MPa, preferably more than or equal to 350 MPa, and further preferably 350 MPa to 600 MPa. In some embodiments of the present disclosure, the surface CS of the non-exposed area of the strengthened photosensitive glass may be 350 MPa, 351 MPa, 395 MPa, 438 MPa, 385 MPa, 391 MPa, 398 MPa, 402 MPa, 422 MPa, 450 MPa, 480 MPa, 500 MPa, 530 MPa, 550 MPa, 580 MPa, or 600 MPa, or a value within a numerical range formed by any two of the above specific values as endpoints; as long as the photosensitive glass with the required properties of the present disclosure can be obtained. It should be understood that, in specific embodiments, any of the above ranges can be combined with any other range.

In some embodiments of the present disclosure, the uniaxial compressive strength of the strengthened photosensitive glass is more than or equal to 200 N, preferably 200 N to 500 N, and more preferably 200 N to 490 N. In some embodiments of the present disclosure, the uniaxial compressive strength of the strengthened curved photosensitive glass of the present disclosure may be 200 N, 250 N, 294 N, 361 N, 392 N, 301 N, 314 N, 375 N, 376 N, 390 N, 400 N, 450 N, 480 N, or 500 N, or a value within a numerical range formed by any two of the above specific values as endpoints; as long as the photosensitive glass with the required properties of the present disclosure can be obtained. It should be understood that, in specific embodiments, any of the above ranges can be combined with any other range.

The photosensitive glass and/or strengthened photosensitive glass provided by the present disclosure can be used in electronic devices, including but not limited to mobile phones, tablet computers, handheld game consoles, portable digital devices (e.g., digital cameras), smart homes, smart wearables (e.g., smart bracelets, smartwatches, smart glasses), can also be used in vehicles, aircraft or vessels, and can also be used in any glass devices requiring photosensitive glass. For example, they can be used for mobile phone back cover glass, smartwatch housing glass, etc.; for example, they can be used for windshields of vehicles, aircraft or vessels, such as front windshields or side windshields.

By way of example, the photosensitive glass and/or strengthened photosensitive glass provided by the present disclosure can be configured to manufacture cover plate glass, and the cover plate glass can be a back cover or a camera protection cover plate of an electronic device such as a mobile phone. By way of example, the photosensitive glass and/or strengthened photosensitive glass with excellent performance provided by the present disclosure can be used in electronic devices. In some embodiments of the present disclosure, an electronic device is provided, which can be a mobile phone (as shown in FIG. 3, the photosensitive glass and/or strengthened photosensitive glass can serve as the back cover of the mobile phone), or a tablet computer, a smart wearable device (as shown in FIG. 4, the photosensitive glass and/or strengthened photosensitive glass can serve as a shell part at the bottom of the smartwatch), etc.

In some embodiments of the present disclosure, the electronic device comprises a smart wearable device worn on the body. It comprises a shell having a top and a bottom, and the shell part at the bottom comprises the photosensitive glass and/or strengthened photosensitive glass of the present disclosure as described above. The bottom is designed to contact the user's skin when worn.

In some embodiments of the present disclosure, as shown in FIG. 3, the electronic device further comprises a camera module 32 located inside the housing. The housing may comprise a camera protection cover plate 31. The camera protection cover plate 31 covers the camera module 32 and is configured to protect the camera module 32. The camera protection cover plate 31 uses the aforementioned photosensitive glass and/or strengthened photosensitive glass. In some embodiments of the present disclosure, the camera protection cover plate 31 may partially use the aforementioned photosensitive glass, or may entirely use the aforementioned photosensitive glass. In some embodiments of the present disclosure, the setting position of the camera protection cover plate 31 is determined according to the setting position of the camera module 32, and it may be located on the front side or the rear side of the electronic device. In some embodiments of the present disclosure, the camera protection cover plate 31 may be a separate structure from the back cover 33. In some other embodiments of the present disclosure, the camera protection cover plate 31 may also be an integrated structure with the back cover 33.

The technical solutions of the present disclosure will be further described in detail below with reference to examples. The examples of the present disclosure described in detail below are exemplary and are only configured to explain the present disclosure and should not be construed as limiting the present disclosure.

### Example 1

(1) Various raw materials were proportioned according to the component ratios in Table 1. The total mass of the configured raw materials was 2000 g, and 10 g of the clarifying agent sodium chloride (NaCl) was added to the configured raw materials. Then, they were mixed for 30 minutes using a V-type mixer to obtain a uniformly mixed raw material mixture.
   The raw material mixture was transferred to a platinum crucible at 1500 °C for melting. The melt was stirred with a platinum stirring rod. The melting time was 10 hours. Subsequently, it was drawn and molded, and continuously drawn into glass bricks of the required specifications. The glass bricks were quickly placed into an annealing furnace at 500 °C and held for 10 hours, then naturally cooled to room temperature to obtain substrate glass bricks.
   The above substrate glass bricks were subjected to sequential cold processing treatments of cutting, CNC machining (the CNC instrument model used in the present disclosure is: RCG500S), and polishing, to prepare substrate glass with dimensions of 50 mm × 50 mm × 1.0 mm.
(2) The substrate glass obtained above was subjected to ultrasonic cleaning for 10 min, then dried in a drying oven;

After cleaning, masking ink was applied to a localized area on the substrate glass, as shown in FIG. 1, the black areas are the masked areas; subsequently, irradiation treatment was performed under parallel ultraviolet light with a wavelength of 310 nm (UVHX800*850 drawer type) for a total of 25 min. The intensity of the ultraviolet irradiation treatment was 120 mW/cm²;

The UV-irradiated glass was subjected to heat treatment according to the heat treatment process in Table 1 to obtain a photosensitive glass; the heat treatment comprised nucleation treatment and crystallization treatment; the heating rates for both nucleation treatment and crystallization treatment were 10 °C/min; the above photosensitive glass was sequentially subjected to cold processing treatments such as laser cutting, splitting, polishing, and chamfering to obtain a photosensitive glass with dimensions of φ30*1.0 mm, as shown in FIG. 2.

### Examples 2 to 8

They were carried out with reference to Example 1 respectively, with the differences being the raw material composition ratios and heat treatment process parameters for Examples 1-8.

Relevant performance tests were conducted on Examples 1-8, and the results are shown in Table 1.

**Table 1**

| Composition( wt%) | Example 1 | Example 2 | Example 3 | Example 4 | Example 5 | Example 6 | Example 7 | Example 8 |
|---|---|---|---|---|---|---|---|---|
| Silica sand | 52.94 | 54.89 | 56.48 | 57.42 | 58.47 | 58.96 | 58.63 | 57.32 |
| Aluminum hydroxide | 9.97 | 9.46 | 8.22 | 9.78 | 8.36 | 9.29 | 8.75 | 9.44 |
| Lithium carbonate | 19.94 | 19.47 | 18.68 | 17.43 | 18.55 | 17.89 | 18.31 | 19.65 |
| Sodium nitrate | 5.45 | 5.18 | 5.36 | 4.66 | 5.18 | 3.77 | 4.85 | 4.36 |
| Potassium nitrate | 5.97 | 5.66 | 5.37 | 5.91 | 4.07 | 5.89 | 4.48 | 4.83 |
| Zirconium oxide | 4.96 | 4.37 | 4.88 | 3.89 | 4.38 | 3.33 | 4.12 | 3.54 |
| Silver nitrate | 0.38 | 0.42 | 0.49 | 0.44 | 0.47 | 0.32 | 0.39 | 0.45 |
| Cerium oxide | 0.05 | 0.06 | 0.07 | 0.08 | 0.09 | 0.05 | 0.07 | 0.1 |
| Sodium antimonate | 0.34 | 0.49 | 0.45 | 0.39 | 0.43 | 0.5 | 0.4 | 0.31 |
| Total | 100.00 | 100.00 | 100.00 | 100.00 | 100.00 | 100.00 | 100.00 | 100.00 |
| Temperature of nucleation treatment / °C | 430 | 440 | 450 | 460 | 480 | 500 | 500 | 500 |
| Time of nucleation treatment /min | 60 | 60 | 90 | 100 | 120 | 140 | 140 | 160 |
| Temperature of crystallization treatment 1 / °C | 500 | 500 | 510 | 510 | 515 | 520 | 525 | 530 |
| Time of crystallization treatment 1 /min | 240 | 180 | 160 | 160 | 160 | 180 | 150 | 145 |
| Temperature of crystallization treatment 2 / °C | 565 | 570 | 575 | 580 | 590 | 600 | 605 | 610 |
| Time of crystallization treatment 2 /min | 240 | 220 | 210 | 195 | 140 | 120 | 95 | 80 |
| Transmittance T₁ of exposed area (850nm) | 1.64% | 1.55% | 1.27% | 0.96% | 0.88% | 0.95% | 1.59% | 2.3% |
| Transmittance T₂ of exposed area (550nm) | 0.00 | 0.00 | 0.00 | 0.00 | 0.00 | 0.00 | 0.00 | 0.00 |
| Transmittance T₃ of non-exposed area (850nm) | 92.03% | 91.76% | 91.83% | 91.69% | 91.80% | 91.92% | 91.85% | 92.21% |
| Transmittance T₄ of non-exposed area (550nm) | 91.24% | 90.82% | 90.77% | 90.73% | 90.88% | 91.05% | 90.74% | 90.86% |

The photosensitive glasses of Examples 1, 3, and 6 were subjected to chemical strengthening treatment. The chemical strengthening treatment was sequentially performed by chemical strengthening in a salt bath of 100 wt% NaNO₃ at 460 °C for 18 hours, and then chemical strengthening in a salt bath of 100 wt% KNO₃ at 440 °C for 20 minutes to obtain strengthened photosensitive glasses.

The raw material components of the photosensitive glasses of Examples 1, 3, and 6 were converted into mass percentages of oxides as shown in Table 2 below; the surface CS of the non-exposed area and the uniaxial compressive strength of the strengthened photosensitive glasses were tested, and the results are shown in Table 3.

**Table 2**

| Composition (wt%) | Example 1 | Example 3 | Example 6 |
|---|---|---|---|
| SiO₂ | 67.99 | 70.99 | 73.30 |
| Al₂O₃ | 8.37 | 6.75 | 7.55 |
| Li₂O | 10.36 | 9.50 | 8.99 |
| Na₂O | 2.62 | 2.55 | 1.81 |
| K₂O | 3.57 | 3.14 | 3.41 |
| ZrO₂ | 6.37 | 6.13 | 4.14 |
| Ag₂O | 0.33 | 0.42 | 0.27 |
| CeO₂ | 0.06 | 0.09 | 0.06 |
| Sb₂O₃ | 0.33 | 0.43 | 0.47 |
| Total | 100 | 100 | 100 |

**Table 3**

| | Example 1 | Example 3 | Example 6 |
|---|---|---|---|
| CS of non-exposed area / MPa | 372 | 398 | 426 |
| Uniaxial compressive strength / N | 302 | 365 | 388 |

Examples 9-10 and Comparative Examples 1-3 were carried out with reference to Example 1, with the differences being that the raw material compositions of Examples 9-10 and Comparative Examples 1-3 were different as shown in Table 4.

Among them, for both Examples 9-10 and Comparative Examples 1-3, the calculations are based on the molar percentage of oxides. The same oxide is provided by different raw materials. Taking the Sb₂O₃ column as an example, in Examples 9-10 and Comparative Examples 1-3, based on the molar percentage of oxides, the content of Sb₂O₃ is 0.37. The difference is that Example 9 uses sodium antimonate as the raw material to provide Sb₂O₃, Example 10 uses ammonium antimonate as the raw material to provide Sb₂O₃, and Comparative Examples 1-3 use antimony oxide (Sb₂O₃) as the raw material to provide Sb₂O₃. Furthermore, the oxide molar percentages of Examples 9-10 were converted into the mass ratio of raw material components as follows: 57.96 wt% of silica sand, 18.34 wt% of lithium carbonate, 8.89 wt% of aluminum hydroxide, 5.30 wt% of potassium nitrate, 5.05 wt% of sodium nitrate, 3.62 wt% of zirconium oxide, 0.43 wt% of silver nitrate, 0.07 wt% of cerium oxide, and a pentavalent antimony salt; wherein, calculated as sodium antimonate, the content of the pentavalent antimony salt is 0.34 wt%; this is within the mass ratio range of the present disclosure.

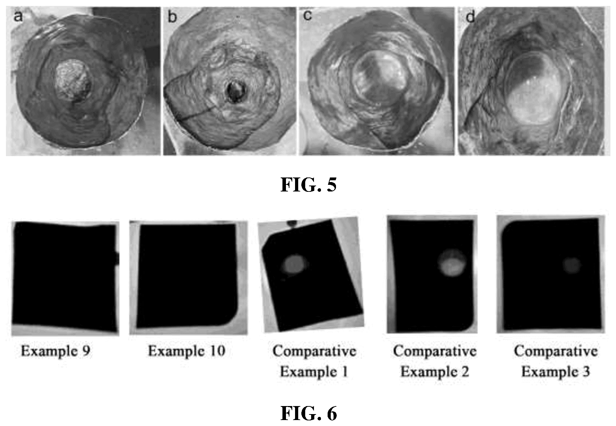

The Ag/Ag₂O concentration (converted to the mass ratio of Ag₂O) on the main surface of the photosensitive glasses prepared in Examples 9-10 and Comparative Examples 1-3, and the transmittance T₃ (850 nm) of their exposed areas were tested. In addition, shielding diagrams of the exposed areas of the photosensitive glasses prepared in Examples 9-10 and Comparative Examples 1-3 in the visible light range were obtained as shown in FIG. 6, and the results are shown in Table 5.

**Table 4**

| | Composition (mol%) | Example 9 | Example 10 | Comparative Example 1 | Comparative Example 2 | Comparative Example 3 |
|---|---|---|---|---|---|---|
| SiO₂ | 71.02 | Silica sand | Silica sand | Silica sand | Silica sand | Silica sand |
| Al₂O₃ | 4.20 | Aluminum oxide | Aluminum oxide | Aluminum oxide | Aluminum oxide | Aluminum oxide |
| Li₂O | 18.29 | Lithium carbonate | Lithium carbonate | Lithium carbonate | Lithium carbonate | Lithium carbonate |
| Na₂O | 2.19 | Sodium nitrate | Sodium nitrate | Sodium nitrate | Sodium nitrate | Sodium nitrate |
| K₂O | 1.93 | Potassium nitrate | Potassium nitrate | Potassium carbonate | Potassium carbonate | Potassium nitrate |
| ZrO₂ | 2.16 | Zirconium oxide | Zirconium oxide | Zirconium oxide | Zirconium oxide | Zirconium oxide |
| CeO₂ | 0.031 | Cerium oxide | Cerium oxide | Cerium oxide | Cerium oxide | Cerium oxide |
| Ag₂O | 0.092 | Silver nitrate | Silver nitrate | Silver oxide | Silver nitrate | Silver oxide |
| Sb₂O₃ | 0.087 | Sodium antimonate | Ammonium antimonate | Antimony oxide | Antimony oxide | Antimony oxide |
| Total | 100 | / | / | / | / | / |
| Whether platinum crucible was corroded | / | No | No | Yes | Yes | Yes |

**Table 5**

| | Example 9 | Example 10 | Comparative Example 1 | Comparative Example 2 | Comparative Example 3 |
|---|---|---|---|---|---|
| Content of Ag₂O in original composition (wt%) | 0.36 | 0.36 | 0.36 | 0.36 | 0.36 |
| Content of Ag₂O in photosensitive glass (wt%) | 0.378 | 0.380 | 0.212 | 0.266 | 0.277 |
| Transmittance T₃ of the exposed area (850nm) /% | 0.6 | 0.7 | 10.4 | 7.7 | 5.6 |

Photographs of the bottom of the crucible after melting for Examples 9-10 and Comparative Examples 1-2 are shown in FIG. 5, wherein a. is a photograph of the bottom of the crucible for Comparative Example 1, b. is a photograph of the bottom of the crucible for Comparative Example 2, c. is a photograph of the bottom of the crucible for Example 9, d. is a photograph of the bottom of the crucible for Example 10.

FIG. 6 shows physical images of shielding in the visible light range for the exposed area of Examples 9-10 and Comparative Examples 1-3 of the present disclosure. The bright light spots transmitting through in Comparative Examples 1-3 are red light.

According to Table 1 above, as well as FIG. 5 and FIG. 6, it can be seen that the photosensitive glass prepared by the present disclosure can ensure the stability of the glass composition during the melting process of Ag-containing photosensitive glass, with no Ag precipitation to corrode the noble metal container; and the exposed area of the prepared photosensitive glass can achieve shielding of optical signals in the visible and near-infrared wavelength ranges.

According to Table 4 and FIG. 5 above, it can be seen that when the molar ratio of oxides is the same, the photosensitive glass prepared without using nitrate raw materials causes severe corrosion to the platinum crucible; while adding some nitrate raw materials can reduce the corrosion, but as long as silver oxide is directly used in the raw materials, it will cause certain corrosion to the platinum crucible. In addition, when the raw materials of the present disclosure simultaneously use sodium nitrate, potassium nitrate, silver nitrate, and sodium antimonate, it can ensure that the platinum crucible is not corroded.

According to Table 5 above, it can be seen that there was no loss of Ag⁺ during the raw material melting and molding process for Examples 9-10, while there was loss of Ag⁺ for Comparative Examples 1-3. This is because in Examples 9-10, sodium nitrate, potassium nitrate, silver nitrate, and antimonate (sodium antimonate or ammonium antimonate) were simultaneously used as raw material components to prepare the photosensitive glass. During melting, there was no conversion of Ag⁺ to Ag precipitation, so the Ag₂O content in the final product was almost the same as the Ag₂O content in the initial composition. In Comparative Examples 1-3, due to the conversion of some Ag⁺ to Ag precipitation at the beginning of melting, the Ag₂O content in the final product was much lower than that in the initial composition. At the same time, the exposed area of the photosensitive glass prepared in Examples 9-10 has excellent shielding performance in the visible light area, while the exposed area of the photosensitive glass prepared in Comparative Examples 1-3 allows red light transmission in the visible light area. Furthermore, the exposed area of the photosensitive glass prepared in Examples 9-10 has lower transmittance at 850 nm, demonstrating good shielding performance.

The above are only specific embodiments of the present disclosure and are not intended to limit the present disclosure. For those skilled in the art, the present disclosure may have various modifications and changes. Any modifications, equivalent replacements, improvements, etc., made within the spirit and principles of the present disclosure shall be included within the protection scope of the present disclosure.

### Industrial Applicability

In summary, the present disclosure provides a photosensitive glass, which not only can ensure the stability of the glass composition during the melting process of Ag₂O-containing photosensitive glass and solve the problem of loss and damage to noble metal containers caused by silver atom Ag⁰ generated from the decomposition of Ag₂O, but also can ensure that the exposed area of the photosensitive glass obtained after subsequent radiation treatment and heat treatment exhibits extremely low optical transmittance in the visible and near-infrared wavelength ranges, thereby achieving shielding of optical signals.

## Claims

1. A photosensitive glass, comprising the following components: 50 wt% to 60 wt% of silica sand, 15 wt% to 22 wt% of lithium carbonate, 6 wt% to 10 wt% of aluminum hydroxide, 3 wt% to 6 wt% of potassium nitrate, 3 wt% to 6 wt% of sodium nitrate, 3 wt% to 5 wt% of zirconium oxide, 0.3 wt% to 0.6 wt% of silver nitrate, 0.05 wt% to 0.10 wt% of cerium oxide, and a pentavalent antimony salt, based on a mass percentage of each component of a raw material in the photosensitive glass; wherein, calculated as sodium antimonate, a mass percentage of the pentavalent antimony salt in the photosensitive glass is 0.3 wt% to 0.8 wt%.

2. The photosensitive glass according to claim 1, wherein the photosensitive glass comprises the following components:
silica sand with a content of 53 wt% to 59 wt%, preferably silica sand with a content of 54.00 wt% to 58.96 wt%, and/or
lithium carbonate with a content of 17 wt% to 20 wt%, preferably lithium carbonate with a content of 17.43 wt% to 19.94 wt%, and/or
aluminum hydroxide with a content of 8 wt% to 10 wt%, preferably aluminum hydroxide with a content of 8.22 wt% to 9.97 wt%, and/or
potassium nitrate with a content of 4 wt% to 6 wt%, preferably potassium nitrate with a content of 4.07 wt% to 5.97 wt%, and/or
sodium nitrate with a content of 3.5 wt% to 5.5 wt%, preferably sodium nitrate with a content of 3.77 wt% to 5.45 wt%, and/or
zirconium oxide with a content of 3 wt% to 5 wt%, preferably zirconium oxide with a content of 3.33 wt% to 4.96 wt%, and/or
silver nitrate with a content of 0.3 wt% to 0.5 wt%, preferably silver nitrate with a content of 0.32 wt% to 0.49 wt%, and/or
cerium oxide with a content of 0.05 wt% to 0.10 wt%, preferably cerium oxide with a content of 0.06 wt% to 0.09 wt%, and/or
the pentavalent antimony salt with a content of 0.3 wt% to 0.7 wt%, preferably the pentavalent antimony salt with a content of 0.3 wt% to 0.5 wt%,
based on the mass percentage of each component of the raw material in the photosensitive glass.

3. The photosensitive glass according to claim 1 or 2, wherein the pentavalent antimony salt comprises at least one selected from the group consisting of NaSbO₃, KSbO₃, NH₄SbO₃, and a hydrate thereof.

4. The photosensitive glass according to any one of claims 1 to 3, wherein a thickness of the photosensitive glass is 0.4 mm to 1.0 mm.

5. The photosensitive glass according to any one of claims 1 to 4, wherein the photosensitive glass comprises an exposed area and a non-exposed area;
when the thickness of the photosensitive glass is 0.40 mm to 1.00 mm, a transmittance T₁ of the exposed area of the photosensitive glass at a wavelength of 850 nm is 0.00% to 5.00%, preferably the transmittance T₁ is 0.00% to 3.00%; and/or
when the thickness of the photosensitive glass is 0.40 mm to 1.00 mm, a transmittance T₂ of the exposed area of the photosensitive glass at a wavelength of 550 nm is 0.00% to 5.00%, preferably the transmittance T₂ is 0.00% to 2.00%; and/or
when the thickness of the photosensitive glass is 0.40 mm to 1.00 mm, a transmittance T₃ of the non-exposed area of the photosensitive glass at a wavelength of 850 nm is more than or equal to 90%; and/or
when the thickness of the photosensitive glass is 0.40 mm to 1.00 mm, a transmittance T₄ of the non-exposed area of the photosensitive glass at a wavelength of 550 nm is more than or equal to 90%.

6. A preparation method for the photosensitive glass according to any one of claims 1 to 5, comprising:
proportioning each component of the raw material, then mixing and melting in a noble metal container, followed by molding, and then performing annealing treatment to obtain a substrate glass;
the substrate glass comprises a first area and a second area, performing masking treatment on the first area, not performing masking treatment on the second area, to obtain a masked substrate glass; and
after performing radiation treatment and heat treatment on the masked substrate glass, obtaining the photosensitive glass having the non-exposed area and the exposed area; wherein the non-exposed area corresponds to the first area, and the exposed area corresponds to the second area.

7. The preparation method according to claim 6, wherein the noble metal container is a container prepared by using at least one metal comprising gold, platinum, and rhodium.

8. The preparation method according to claim 6 or 7, wherein a temperature of the melting is 1400°C to 1650°C, and a time of the melting is 6 h to 48 h; and/or a temperature of the annealing is 400°C to 500°C, and a time of the annealing is 8 h to 24 h.

9. The preparation method according to any one of claims 6 to 8, wherein the radiation treatment comprises ultraviolet irradiation treatment.

10. The preparation method according to claim 9, wherein a wavelength of the ultraviolet irradiation treatment is 300 nm to 320 nm, an intensity of the ultraviolet irradiation treatment is 20 mW/cm² to 360 mW/cm², and a time of the ultraviolet irradiation treatment is 5 min to 60 min.

11. The preparation method according to any one of claims 6 to 10, wherein the heat treatment comprises nucleation treatment and crystallization treatment.

12. The preparation method according to claim 11, wherein a heating rate of the nucleation treatment is 1°C/min to 10°C/min; and/or
a temperature of the nucleation treatment is 430 °C to 540 °C; and/or
a time of the nucleation treatment is 30 min to 360 min; and/or
a heating rate of the crystallization treatment is 1°C/min to 10°C/min; and/or
a temperature of the crystallization treatment is 540 °C to 800 °C; and/or
a time of the crystallization treatment is 30 min to 240 min.

13. A strengthened photosensitive glass, comprising a strengthening layer and a tensile stress layer, wherein the strengthening layer extends inward from a surface of the strengthened photosensitive glass, a thickness of the strengthened photosensitive glass is t, and a thickness of the strengthening layer is greater than 0 and less than or equal to 0.22 t;
the tensile stress layer and/or a center of the strengthened photosensitive glass comprises the following components:
SiO₂: 65.00% to 74.00%, Al₂O₃: 5.00% to 10.00%, Li₂O: 7.90% to 12.00%, Na₂O: 1.00% to 3.00%, K₂O: 1.50% to 3.80%, ZrO₂: 3.50% to 6.50%, Ag₂O: 0.20% to 0.50%, CeO₂: 0.07% to 0.13% and Sb₂O₃: 0.20% to 0.50%, based on a mass percentage of oxides;
the strengthening layer comprises the following components:
SiO₂: 65.00% to 74.00%, Al₂O₃: 5.00% to 10.00%, Na₂O: 4.00% to 16.00%, K₂O: 2.0% to 5.0%, ZrO₂: 3.50% to 6.50%, Ag₂O: 0.20% to 0.50%, CeO₂: 0.07% to 0.13% and Sb₂O₃: 0.20% to 0.50%, based on the mass percentage of oxides; a content of Li₂O in the strengthening layer is lower than a content of Li₂O in the tensile stress layer and/or at the center of the strengthened photosensitive glass;
wherein, Na₂O is obtained from sodium nitrate, K₂O is obtained from potassium nitrate, Ag₂O is obtained from silver nitrate, and Sb₂O₃ is obtained from a pentavalent antimony salt; and
the strengthened photosensitive glass comprises a non-exposed area and an exposed area.

14. The strengthened photosensitive glass according to claim 13, wherein a uniaxial compressive strength of the strengthened photosensitive glass is more than or equal to 200 N, preferably 200 N to 500 N, more preferably 200 N to 490 N.

15. A cover plate glass made of the photosensitive glass according to any one of claims 1 to 5, the photosensitive glass prepared by the preparation method according to any one of claims 6 to 12, or the strengthened photosensitive glass according to any one of claims 13 to 14.

16. An electronic device, comprising the photosensitive glass according to any one of claims 1 to 5, the photosensitive glass prepared by the preparation method according to any one of claims 6 to 12, or the strengthened photosensitive glass according to any one of claims 13 to 14.

17. The electronic device according to claim 16, wherein the electronic device comprises a shell having a top and a bottom, a shell part at the bottom comprises the photosensitive glass according to any one of claims 1 to 5, the photosensitive glass prepared by the preparation method according to any one of claims 6 to 12, or the strengthened photosensitive glass according to any one of claims 13 to 14.

18. The electronic device according to claim 16 or 17, wherein the electronic device further comprises a camera component, a housing of the electronic device comprises a camera protection cover plate, the camera protection cover plate covers the camera component, and the camera protection cover plate comprises the photosensitive glass according to any one of claims 1 to 5, the photosensitive glass prepared by the preparation method according to any one of claims 6 to 12, or the strengthened photosensitive glass according to any one of claims 13 to 14.

19. Use of the photosensitive glass according to any one of claims 1 to 5, the photosensitive glass prepared by the preparation method according to any one of claims 6 to 12, or the strengthened photosensitive glass according to any one of claims 13 to 14 in the manufacture of a component for a mobile phone, a smartwatch, a wearable device, a camera module, or a vehicle.
